# EUROPEAN PATENT APPLICATION

(11) **EP 3 831 524 A1**
(43) Date of publication of application: **09.06.2021**
(21) Application number: 19843824.4
(22) Date of filing: 31.07.2019
(51) Int. Cl.: B23K 1/08, B23K 1/00, H05K 3/34

(54) **INFORMATION PROCESSING DEVICE, MANAGEMENT SYSTEM, CONTROL PROGRAM, AND METHOD FOR CONTROLLING INFORMATION PROCESSING DEVICE**

(30) Priority: 31.07.2018 JP 2018144397
(71) Applicant: OMRON Corporation, Shiokoji-dori, Shimogyo-ku, Kyoto-shi Kyoto 600-8530 (JP)
(72) Inventor: TAKEDA, Kazuhiro, Kizugawa-shi, Kyoto 619-0283 (JP); SAKASHITA, Shota, Kizugawa-shi, Kyoto 619-0283 (JP); KUBOTA, Tetsuro, Kizugawa-shi, Kyoto 619-0283 (JP); IUCHI, Kensuke, Kizugawa-shi, Kyoto 619-0283 (JP); OMOTO, Hideaki, Kizugawa-shi, Kyoto 619-0283 (JP)
(74) Representative: Becker, Eberhard
(86) International application number: PCT/JP2019/030048
(87) International publication number: WO 2020/027208

(57) **Abstract**

The present invention determines, with high detection performance, abnormalities in jet soldering devices. The present invention comprises: an acquisition unit (421) that acquires a feature value for the imaged jet shape of solder jetted in a solder jetting device (70); and an abnormality determination unit (422) that uses the feature value to determine abnormalities in the jet soldering device.

## Description

### BACKGROUND OF THE INVENTION

### 1. Field of the Invention

The invention relates to an information processing device, a management system, a control program, and a control method for an information processing device for determining abnormalities in a jet soldering device.

### 2. Description of Related Art

Techniques are known for adjusting solder jet in a jet soldering device. For example, Patent Documents 1 to 3 disclose techniques for detecting the height of the solder that is jet, adjusting the height of the solder that is jet, etc.

### [Prior Art Documents]

### [Patent Documents]

Patent Document 1: Japanese Laid-open No. H11-047922
Patent Document 2: Japanese Laid-open No. H05-185209
Patent Document 3: Japanese Laid-open No. H01-205593

### SUMMARY OF THE INVENTION

### [Problems to be Solved by the Invention]

In the conventional technologies as described above, the height of the solder is adjusted according to the temporary height of the solder. Therefore, when a device that performs abnormality determination with respect to a jet soldering device is to be realized by using these technologies, the abnormality determination is performed by using the height of the jet solder.

However, when an abnormality occurs in the jet soldering device, features of the jet shape of the solder other than height may also change. Therefore, in the case where the abnormalities are determined by using only the height of the solder, it is possible that the abnormalities cannot be detected correctly.

An objective of an aspect of the invention is to realize an information processing device, etc., capable of determining, with high detection performance, abnormalities in jet soldering devices.

### [Means to Solve Problems]

In order to solve the above issues, an aspect of the invention provides an information processing device. The information processing device includes: an acquisition unit, acquiring a feature value for an imaged jet shape of solder jet in a jet soldering device; and an abnormality determination unit, determining an abnormality of the jet soldering device by using the feature value.

In addition, an aspect of the invention provides a control method for an information processing device. The control method includes: an acquisition step for acquiring a feature value for an imaged jet shape of solder jet in a jet soldering device; and an abnormality determination step for determining an abnormality of the jet soldering device by using the feature value.

The jet shape of the solder of the jet soldering device is correlated with the abnormality of the jet soldering device. For example, as the jet shape, a feature value other than height can also be used. Therefore, in the configuration in which the state of the jet soldering device is determined from the jet shape of the solder, the abnormality in the jet soldering device can be determined with high detection performance.

Accordingly, the user can recognize the quality deterioration tendency of the solder from the determination and the effect of being capable of avoiding soldering defects of the jet soldering device in advance is achieved.

The abnormality determination unit may determine the abnormality of the jet soldering device by using the feature value of the jet shape that is imaged from top.

In the jet soldering device, the abnormality of the solder jet state influences the jet shape imaged from the top. Therefore, according to the configuration, for example, the effect of being capable of determining the abnormality of the jet state of the solder jet from the jet soldering device from the feature value for the jet shape of the solder imaged from the top is achieved.

The abnormality determination unit may determine the abnormality of the jet soldering device by using, as the feature value, at least one of an elliptical major axis, an elliptical minor axis, a flatness ratio, an area, a perimeter, circularity, an inscribed circle radius, a circumscribed circle radius, and a gravity center coordinate of the jet shape imaged from the top.

The elliptical major axis, the elliptical minor axis, the flatness ratio, the area, the perimeter, the circularity, the inscribed circle radius, the circumscribed circle radius, and the gravity center coordinate of the jet shape of the solder imaged from the top of the jet soldering device is correlated with the abnormality of the solder jet state.

Thus, according to the above configuration, by using at least one of the elliptical major axis, the elliptical minor axis, the flatness ratio, the area, the perimeter, the circularity, the inscribed circle radius, the circumscribed circle radius, and the gravity center coordinate of the jet shape imaged from the top, the effect of being capable of determining the abnormality with respect to the solder jet state of the jet soldering device with high detection performance is achieved.

The abnormality determination unit may determine the abnormality of the jet soldering device by using the feature value of the jet shape that is imaged laterally.

In the jet soldering device, the abnormality of the solder jet state influences the jet shape imaged laterally. Therefore, according to the configuration, for example, the effect of being capable of determining the abnormality of the jet state of the solder jet from the jet soldering device from the feature value for the jet shape of the solder is achieved.

The abnormality determination unit may determine the abnormality of the jet soldering device by using, as the feature value, a width of the jet shape imaged laterally or a position of a vertex of the jet shape in a horizontal direction.

The width of the jet shape of the solder imaged from a lateral side of the jet soldering device and the position of the vertex of the jet shape in the horizontal direction are correlated with the abnormality of the solder jet state.

Thus, according to the above configuration, by using the width of the jet shape imaged laterally or the position of the vertex of the jet shape in the horizontal direction, the effect of being capable of determining the abnormality with respect to the solder jet state of the jet soldering device with high detection performance is achieved.

In order to solve the above issues, an aspect of the invention provides a management system. The management system includes: a camera, imaging a jet shape of a solder liquid jet in a jet soldering device; an image processing device, calculating a feature value for the jet shape from an image imaged by the camera; and any of the above information processing device.

According to the above configuration, the effect of being capable of realizing an abnormality determination system capable of determining the abnormality of the jet soldering device is achieved.

In order to solve the above issues, an aspect of the invention provides a control program. The control program is a control program for a computer to function as the information processing device, and the computer functions as the acquisition unit and the abnormality determination unit.

### [Inventive Effects]

According to an aspect of the invention, the abnormalities in the jet soldering device can be determined with high detection performance.

### BRIEF DESCRIPTION OF THE DRAWINGS

FIG. 1 is a block diagram illustrating a configuration of main parts of a controller according to an embodiment of the invention.
FIG. 2 is a diagram illustrating an example of an application example of a controller in a management system according to an embodiment of the invention.
In FIG. 3, (a) to (e) are views illustrating jet shapes in cases where a solder liquid is jet by using a jet soldering device in a normal solder jet state and a solder liquid is jet by using a jet soldering device in an abnormal solder jet state.
FIG. 4 is a view illustrating a cross-section of a jet soldering device according to an embodiment of the invention.
In FIG. 5, (a) to (c) are diagrams illustrating actual values of elliptical major axes and elliptical minor axes of jet shapes imaged from the top in cases where a solder liquid is jet by using a jet soldering device in a normal solder jet state and a solder liquid is jet by using a jet soldering device in an abnormal solder jet state.
FIG. 6 is a diagram illustrating actual values of flatness ratios of jet shapes imaged from the top in cases where a solder liquid is jet by using a jet soldering device in a normal solder jet state and a solder liquid is jet by using a jet soldering device in an abnormal solder jet state.
FIG. 7 is a diagram illustrating actual values of areas of jet shapes imaged from the top in cases where a solder liquid is jet by using a jet soldering device in a normal solder jet state and a solder liquid is jet by using a jet soldering device in an abnormal solder jet state.
FIG. 8 is a diagram illustrating actual values of perimeters of jet shapes imaged from the top in cases where a solder liquid is jet by using a jet soldering device in a normal solder jet state and a solder liquid is jet by using a jet soldering device in an abnormal solder jet state.
FIG. 9 is a diagram illustrating actual values of circularity of jet shapes imaged from the top in cases where a solder liquid is jet by using a jet soldering device in a normal solder jet state and a solder liquid is jet by using a jet soldering device in an abnormal solder jet state.
FIG. 10 is a diagram illustrating actual values of inscribed circle radii of jet shapes imaged from the top in cases where a solder liquid is jet by using a jet soldering device in a normal solder jet state and a solder liquid is jet by using a jet soldering device in an abnormal solder jet state.
FIG. 11 is a diagram illustrating actual values of circumscribed circle radii of jet shapes imaged from the top in cases where a solder liquid is jet by using a jet soldering device in a normal solder jet state and a solder liquid is jet by using a jet soldering device in an abnormal solder jet state.
FIG. 12 is a diagram illustrating actual values of widths of jet shapes imaged laterally in cases where a solder liquid is jet by using a jet soldering device in a normal solder jet state and a solder liquid is jet by using a jet soldering device in an abnormal solder jet state.
FIG. 13 is a view illustrating gravity center coordinates of jet shapes imaged from the top in cases where a solder liquid is jet by using a jet soldering device in a normal solder jet state and a solder liquid is jet by using a jet soldering device in an abnormal solder jet state.
FIG. 14 is a view illustrating vertex coordinates of jet shapes imaged laterally in cases where a solder liquid is jet by using a jet soldering device in a normal solder jet state and a solder liquid is jet by using a jet soldering device in an abnormal solder jet state.
FIG. 15 is a flowchart illustrating an example of a flow of an abnormality notification process of a management system according to an embodiment of the invention.

### DESCRIPTION OF THE EMBODIMENTS

### [Embodiment]

In the following, an embodiment of the invention will be described in detail.

### 1. Application Example

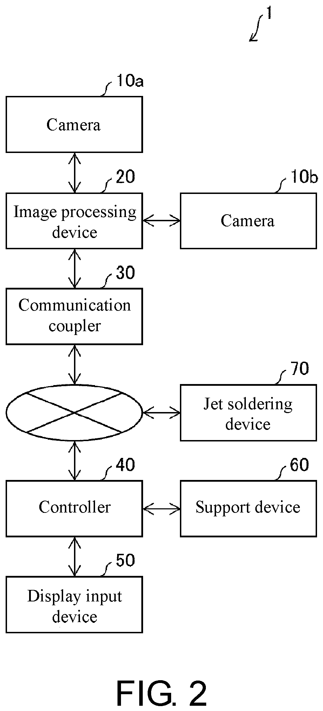

FIG. 2 is a diagram illustrating an example of an application example of a controller (information processing device) 40 in a management system 1. Firstly, the outline of an application example of the controller 40 is described by using FIG. 2.

In a jet soldering device 70, for example, when the solder deteriorates due to oxidation, etc., oxide debris of the solder adheres to the inner surface of a nozzle for jetting the solder and clogs the nozzle. In addition, in the jet soldering device 70, the tip of the nozzle may be worn out due to use for a long time, which makes the jet flow not uniform and causes a one-sided flow in which the solder flow is deviated toward a direction. In addition, when the temperature of the solder stored in the jet soldering device 70 decreases, the solder is jet in a cured state and causes an abnormality of the jet shape of the solder. These abnormalities of the solder jet states cause an insufficient solder amount during soldering, a soldering defect such as a bridge due to the solder, etc., and lower the product yield.

The management system 1 is a system which determines the abnormalities of the jet soldering device 70. The management system 1 includes a camera 10a, a camera 10b, a controller 40, the jet soldering device 70, etc. The detailed configuration of the management system 1 will be described in the following.

The controller 40 acquires a feature value for an imaged jet shape of the solder jet in the jet soldering device 70. Here, the feature value for the jet shape is a numerical data indicating a jet shape. In addition, the controller 40 determines whether the jet soldering device 70 is abnormal by using the feature value.

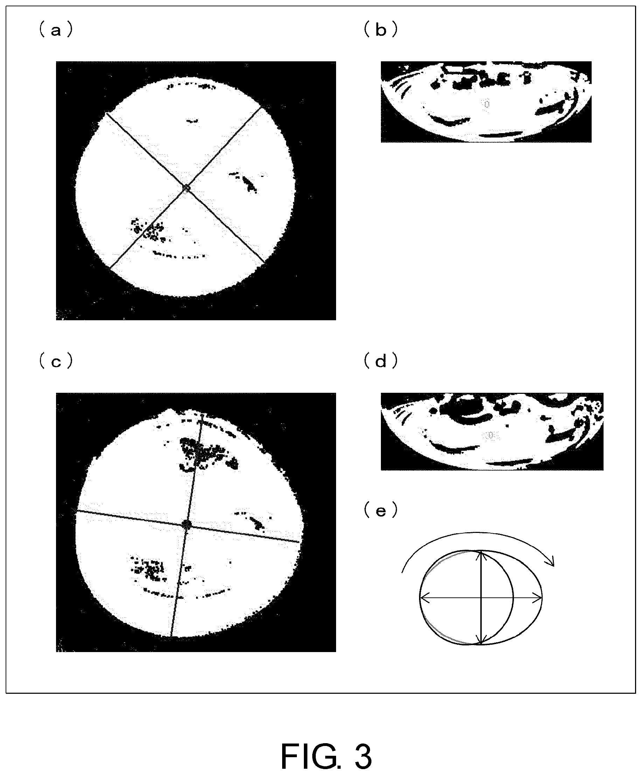

FIG. 3 illustrates the jet shapes in the cases where a solder liquid is jet by using the jet soldering device 70 in a normal solder jet state and the solder liquid is jet by using the jet soldering device 70 in an abnormal solder jet state (a state in which a one-sided flow occurs). (a) and (b) of FIG. 3 are binarized images of jet shapes in the case where the solder liquid is jet in the normal solder jet state. (a) of FIG. 3 is an image imaged from the top of the jet shape. (b) of FIG. 3 is an image imaged from a lateral side of the jet shape. (c) and (d) of FIG. 3 are binarized images of jet shapes in the case where the solder liquid is jet in the abnormal solder jet state. (c) of FIG. 3 is an image imaged from the top of the jet shape. (d) of FIG. 3 is an image imaged from a lateral side of the jet shape. In (b) and (d) of FIG. 3, the jet direction of the solder liquid is reversed from the actual jet direction. In these figures, the solder liquid is jet toward the lower side. (e) of FIG. 3 is a schematic view illustrating a change of the jet shape of the solder liquid when is viewed from the top, in a case where the solder jet state changes from normal to abnormal.

As shown in FIG. 3, in the jet soldering device 70, the abnormalities of the solder jet state influence the height, the width, the elliptical major axis, the elliptical minor axis, the flatness ratio, the area, the perimeter, the circularity, the inscribed circle radius, the circumscribed circle radius, and the gravity center coordinate, etc., of the jet shape of the solder imaged from a fixed position.

Specifically, with the solder flow being deviated toward a direction, a one-sided solder flow occurs. Therefore, as the abnormalities of the solder jet state progress, the jet shape, when viewed from the top, may change from a circular shape to an elliptical shape.

Therefore, for example, an abnormality of the jet state of the solder jet from the jet soldering device 70 can be determined from at least one feature value among the height, the width, the elliptical major axis, the elliptical minor axis, the flatness ratio, the area, the perimeter, the circularity, the inscribed circle radius, the circumscribed circle radius, and the gravity center coordinate, etc., of the jet shape of the solder.

If an element other than the height, the width, the elliptical major axis, the elliptical minor axis, the flatness ratio, the area, the perimeter, the circularity, the inscribed circle radius, the circumscribed circle radius, and the gravity center coordinate, etc., of the jet shape of the solder is an element of the jet shape influenced by the abnormalities of the solder jet state, such an element can also be applied in the abnormality determination.

As described above, the jet shape (height as well as feature values other than height) of the solder of the jet soldering device 70 is correlated with the abnormalities of the jet soldering device 70. For example, as the jet shape, a feature value other than height can also be used. Therefore, in the configuration in which the state of the jet soldering device 70 is determined from the jet shape that is imaged, the abnormalities in the jet soldering device 70 can be determined with high detection performance.

Accordingly, the user can recognize the quality deterioration tendency of the solder from the determination and the effect of being capable of avoiding soldering defects of the jet soldering device in advance is achieved.

### 2. Configuration Example

Then, an example of the management system 1 according to the embodiment will be described.

### (Management System 1)

As shown in FIG. 2, the management system 1 includes the camera 10a, the camera 10b, an image processing device 20, a communication coupler 30, the controller 40, a display input device 50, a support device 60, and the jet soldering device 70.

### (Jet Soldering Device 70)

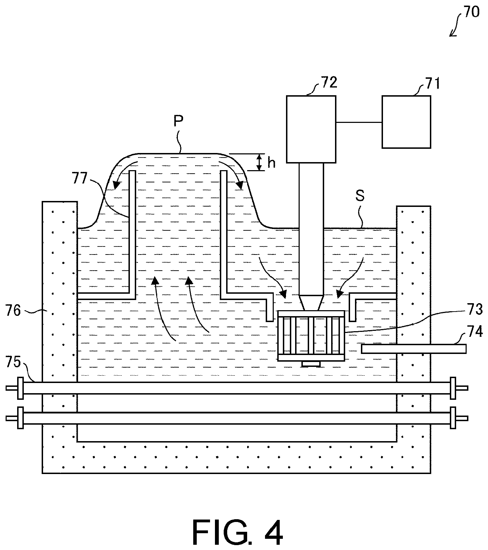

FIG. 4 is a view illustrating a cross-section of the jet soldering device 70 according to the embodiment. The jet soldering device 70 jets a dissolved solder liquid, and performs soldering on a substrate, etc. As shown in FIG. 4, the jet soldering device 70 includes a motor 71, a transmission 72, a pump 73, a thermocouple 74, a heater 75, a solder tank 76, and a nozzle 77.

The jet soldering device 70 makes the dissolved solder liquid flow into the nozzle 77 by using a pressure generated by the pump 73 and jets the solder liquid from the nozzle 77. In FIG. 4, a height h is the height from the end of the nozzle 77 to a liquid surface p of the jet solder liquid.

In addition, as shown in FIG. 4, the pump 73 includes the motor 71 and the transmission 72. For example, the controller 40 may also control the rotation speed of the motor 71, the transmission 72, etc., via a network and control the height of the jet flow of the solder liquid.

In addition, the thermocouple 74 detects the temperature of the solder stored in the solder tank 76. For example, a signal indicating the detection value detected by the thermocouple 74 may be output to the controller 40 via the network. The controller 40 may refer to the detected value detected by the thermocouple 74 and control the heater 75 via the network, and manage the temperature of the solder stored in the solder tank 76.

### (Camera 10a, Camera 10b)

The camera 10a and the camera 10b image the jet shape of the solder liquid jet in the jet soldering device 70 from fixed positions. For example, the camera 10a images the jet shape from the top, and the camera 10b laterally images the jet shape.

It is not required to dispose the camera 10a right on the top the jet solder liquid. The camera 10a may be disposed within a predetermined range from the top of the jet solder liquid. That is, the camera 10a may also image the jet shape from an obliquely upper side. The camera 10a and the camera 10b output the imaged image data to the image processing device 20. For example, the camera 10a and the camera 10b may image the jet shape at an interval of 100 ms. While the embodiment is described with the configuration of the management system 1 including two cameras, i.e., the camera 10a and the camera 10b, it suffices as long as the management system includes at least one camera.

### (Image Processing Device 20)

The image processing device 20 calculates the feature value (numerical data) of the height, the width, the elliptical major axis, the elliptical minor axis, the flatness ratio, the area, the perimeter, the circularity, the inscribed circle radius, the circumscribed circle radius, and the gravity center coordinate, etc., of the jet shape of the solder from the image data output from the camera 10a and the camera 10b. The image processing device 20 outputs a signal indicating the calculated feature value to the controller 40 via the communication coupler 30. The image processing device 20 may calculate each feature value after binarizing the image data output from the camera 10a and the camera 10b, and may also directly calculate each feature value from the image data output from the camera 10a and the camera 10b.

### (Communication Coupler 30)

The communication coupler 30 is a relay device which relays the communication between a superordinate network and the image processing device 20. The communication coupler 30 relays the communication between an apparatus including the superordinate network and the image processing device 20.

### (Controller 40)

The controller 40 is a control device that controls the entire management system 1, and may use a programmable logic controller (PLC). The controller 40 operates as a master device of the communication coupler 30 and the jet soldering device 70 in the management system 1. In addition, in the embodiment, the controller 40 determines the abnormality of the jet soldering device 70. The controller 40 can be replaced with a control program executed by a data server, a client server, etc.

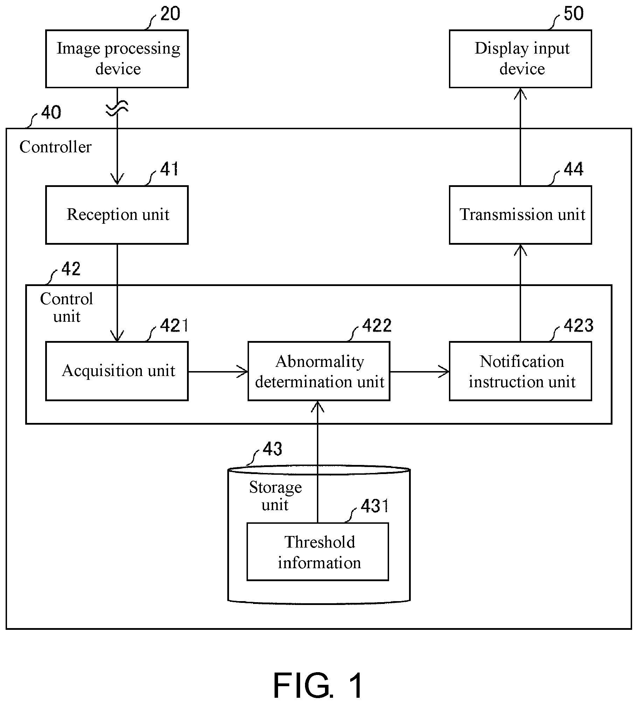

FIG. 1 is a block diagram illustrating a configuration of main parts of the controller 40. As shown in FIG. 1, the controller 40 includes a reception unit 41, a control unit 42, a storage unit 43, and a transmission unit 44.

### (Reception unit 41)

The reception unit 41 receives a signal from an external apparatus. In the embodiment, specifically, the reception unit 41 receives the signal representing the feature value for the jet shape calculated by the image processing device 20 from the image processing device 20. The reception unit 41 outputs the received signal to an acquisition unit 421 of the control unit 42.

### (Control unit 42)

The control unit 42 includes a central processing unit (CPU), a random access memory (RAM), a read only memory (ROM), etc., and controls respective configuration elements in response to information processing. The control unit 42 includes the acquisition unit 421, an abnormality determination unit 422, and a notification instruction unit 423.

### (Acquisition unit 421)

The acquisition unit 421 acquires the signal indicating the feature value for the imaged jet shape of the solder jet in the jet soldering device 70 from the reception unit 41.

### (Abnormality determination unit 422)

The abnormality determination unit 422 determines the abnormality of the jet soldering device 70 by using the feature value for the jet shape. Specifically, the abnormality determination unit 422 compares the feature value for the jet shape with a predetermined threshold. In response to the result of the comparison, the abnormality determination unit 422 determines whether the jet soldering device 70 is abnormal. When determining that the jet soldering device 70 is abnormal, the abnormality determination unit 422 outputs a signal indicating the abnormality to the notification instruction unit 423. The abnormality determination unit 422 may refer to threshold information 431 indicating the threshold of the feature value (height, width, elliptical major axis, elliptical minor axis, flatness ratio, area, perimeter, circularity, inscribed circle radius, circumscribed circle radius, and gravity center coordinate, etc.) of the jet shape stored in the storage unit 43 and perform the abnormality determination.

For example, the abnormality determination unit 422 may determine the abnormality of the jet soldering device 70 by using at least one of the elliptical major axis, the elliptical minor axis, the flatness ratio, the area, the perimeter, the circularity, the inscribed circle radius, the circumscribed circle radius, and the gravity center coordinate of the jet shape imaged from the top.

The elliptical major axis, the elliptical minor axis, the flatness ratio, the area, the perimeter, the circularity, the inscribed circle radius, the circumscribed circle radius, and the gravity center coordinate of the jet shape of the solder imaged from the top of the jet soldering device 70 is correlated with the abnormality of the solder jet state. Consequently, according to the above configuration, the abnormality determination with respect to the solder jet state of the jet soldering device 70 can be executed with high detection performance.

In addition, the abnormality determination unit 422 may also determine the abnormality of the jet soldering device 70 by using the width of the jet shape imaged laterally or the position of the vertex of the jet shape in the horizontal direction.

The width of the jet shape of the solder imaged from a lateral side of the jet soldering device 70 and the position of the vertex of the jet shape in the horizontal direction are correlated with the abnormality of the solder jet state. Consequently, according to the above configuration, the abnormality determination with respect to the solder jet state of the jet soldering device 70 can be executed with high detection performance.

For example, the abnormality determination unit 422 may perform the determination by using the imaged jet shape when the jet soldering device 70 returns to a home position. Nevertheless, the timing at which the jet shape is imaged is not particularly limited.

In addition, the abnormality determination unit 422 may determine the abnormality of the jet soldering device 70 from one feature value. The abnormality determination unit 422 may also determine whether a plurality of feature values are equal to or greater than thresholds, and comprehensively determine the abnormality of the jet soldering device 70 from these determination results. That is, the abnormality determination unit 422 may also determine the abnormality by using multiple types of feature values.

### (Feature Values for Jet Shape in Normal State and Abnormal State)

In the following, the feature values for the jet shapes in the normal solder jet state and the abnormal solder jet state are described in detail.

### (Elliptical Major Axis and Elliptical Minor Axis of Jet Shape)

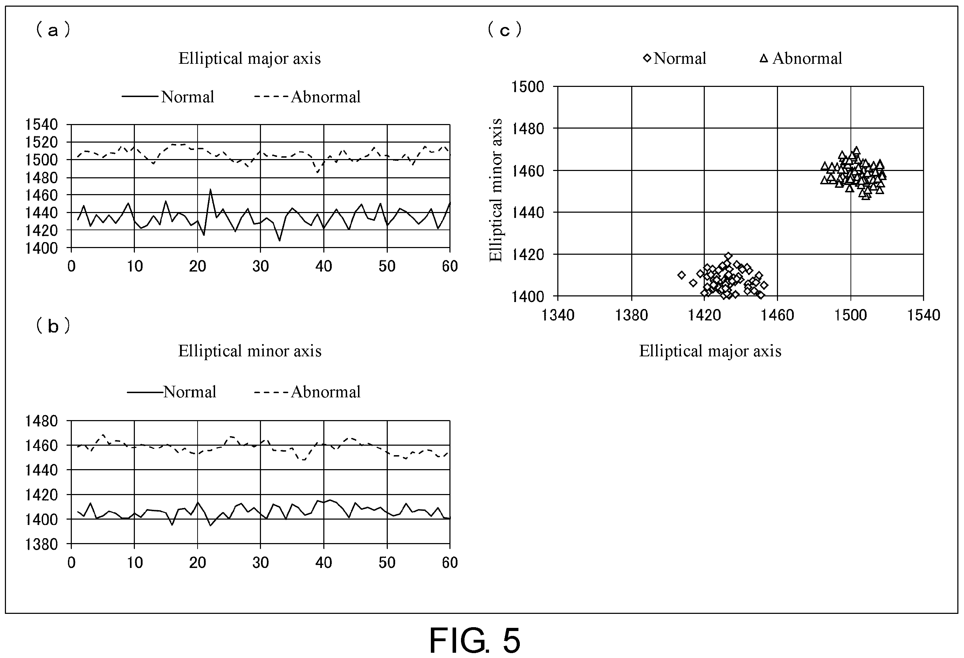

FIG. 5 illustrates an example of actual values of the elliptical major axes and the elliptical minor axes of the jet shapes imaged from the top in the cases where the solder liquid is jet by using the jet soldering device 70 in the normal solder jet state and the solder liquid is jet by using the jet soldering device 70 in the abnormal solder jet state (the state in which an one-sided flow occurs).

(a) of FIG. 5 is a graph in which the horizontal axis is set as time, the vertical axis is set as the elliptical major axis of the jet shape, and the elliptical major axis of the jet shape of the solder liquid is shown. (b) of FIG. 5 is a graph in which the horizontal axis is set as time, the vertical axis is set as the elliptical minor axis of the jet shape, and the elliptical minor axis of the jet shape of the solder liquid is shown. (c) of FIG. 5 is a graph in which the horizontal axis is set as the elliptical major axis, the vertical axis is set as the elliptical minor axis, and the distributions of the jet shapes in the normal state and the abnormal state are shown.

The actual values are the elliptical major axes and the elliptical minor axes of the jet shapes calculated by performing an image process on the imaged jet shapes. More specifically, the elliptical major axes and the elliptical minor axes are calculated by processing the jet shapes imaged every 100 ms by an image processing device. The horizontal axes of (a) and (b) of FIG. 5 show the number of times the image process is performed. For example, the value "10" shown on the horizontal axis indicates that the image process has been performed for 10 times, and it has been 100 ms * 10, i.e., 1 sec., since the measurement starts. In addition, the horizontal axes of (a) and (b) of FIG. 5 show the value of the elliptical major axis or the elliptical minor axis. Also, the values of the elliptical major axis or the elliptical minor axis shown in (a) to (c) of FIG. 5 are values used for convenience, and are not conventionally defined physical quantities.

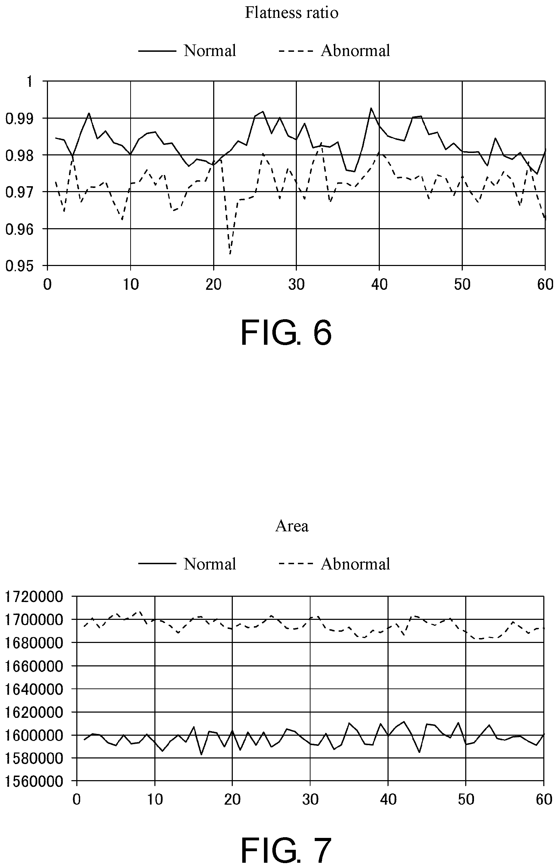

The values of the horizontal axes (time) and the values (actual values) of the vertical axes in the graphs shown in FIGs. 6 to 12 are the same as those of FIG. 5.

As shown in (a) to (c) of FIG. 5, in the case where the solder liquid is jet in the normal solder jet state, the elliptical major axis and the elliptical short axis of the jet shape are smaller than the case where the solder liquid is jet in the abnormal solder jet state. Accordingly, in the case where the elliptical major axis or the elliptical minor axis of the jet shape is used as the feature value for determining the abnormality of the jet soldering device 70, the abnormality determination unit 422 performs the following determination. In the case where the elliptical major axis or the elliptical minor axis is equal to or less than the predetermined threshold, the abnormality determination unit 422 determines that the jet soldering device 70 is not abnormal. In addition, in the case where the elliptical major axis or the elliptical minor axis is greater than the predetermined threshold, the abnormality determination unit 422 determines that the jet soldering device 70 is abnormal.

### (Flatness Ratio of Jet Shape)

FIG. 6 illustrates an example of actual values of the flatness ratios of the jet shapes imaged from the top in the cases where the solder liquid is jet by using the jet soldering device 70 in the normal solder jet state and the solder liquid is jet by using the jet soldering device 70 in the abnormal solder jet state (the state in which an one-sided flow occurs). FIG. 6 is a graph in which the horizontal axis is set as time, the vertical axis is set as the flatness ratio of the jet shape.

Here, when the jet shape is regarded as elliptical, the flatness ratio is represented as "minor axis M/major axis L". The jet shape of the jet soldering device 70 in the normal solder jet state is close to a perfect circle, and the flatness ratio is close to 1.

As shown in FIG. 6, in the case where the solder liquid is jet in the normal solder jet state, the flatness ratio of the jet shape is greater than the case where the solder liquid is jet in the abnormal solder jet state. Accordingly, in the case where the flatness ratio of the jet shape is used as the feature value for determining the abnormality of the jet soldering device 70, the abnormality determination unit 422 performs the following determination. In the case where the flatness ratio of the jet shape is greater than the predetermined threshold, the abnormality determination unit 422 determines that the jet soldering device 70 is not abnormal. In the case where the flatness ratio of the jet shape is equal to or less than the predetermined threshold, the abnormality determination unit 422 determines that the jet soldering device 70 is abnormal.

### (Area of Jet Shape)

FIG. 7 illustrates actual values of the area of the jet shapes imaged from the top in the cases where the solder liquid is jet by using the jet soldering device 70 in the normal solder jet state and the solder liquid is jet by using the jet soldering device 70 in the abnormal solder jet state (the state in which an one-sided flow occurs). FIG. 7 is a graph in which the horizontal axis is set as time, the vertical axis is set as the area of the jet shape.

As shown in FIG. 7, in the case where the solder liquid is jet in the normal solder jet state, the area of the jet shape is smaller than the case where the solder liquid is jet in the abnormal solder jet state. Accordingly, in the case where the area of the jet shape is used as the feature value for determining the abnormality of the jet soldering device 70, the abnormality determination unit 422 performs the following determination. In the case where the area of the jet shape is within the predetermined threshold, the abnormality determination unit 422 determines that the jet soldering device 70 is not abnormal. In the case where the area of the jet shape is greater than the predetermined threshold, the abnormality determination unit 422 determines that the jet soldering device 70 is abnormal.

### (Perimeter of Jet Shape)

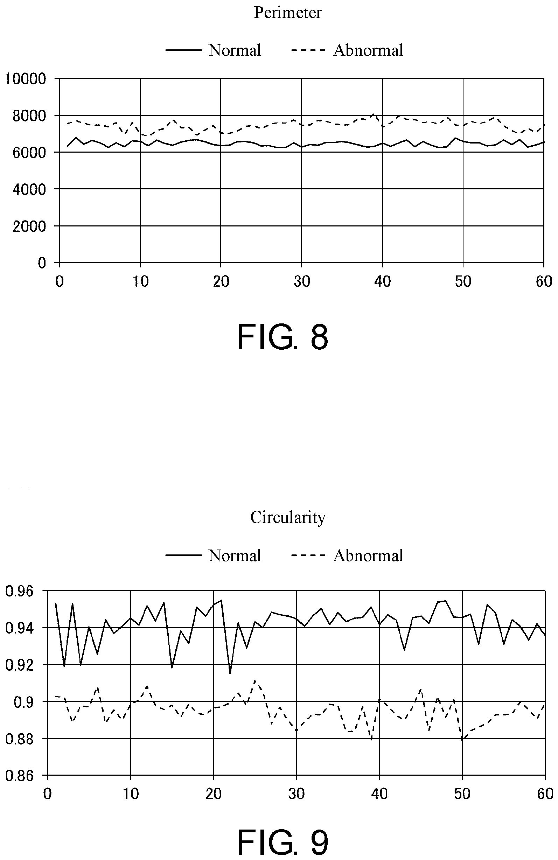

FIG. 8 illustrates actual values of the perimeter of the jet shapes imaged from the top in the cases where the solder liquid is jet by using the jet soldering device 70 in the normal solder jet state and the solder liquid is jet by using the jet soldering device 70 in the abnormal solder jet state (the state in which an one-sided flow occurs). FIG. 8 is a graph in which the horizontal axis is set as time, the vertical axis is set as the perimeter (length of the periphery) of the jet shape.

As shown in FIG. 8, in the case where the solder liquid is jet in the normal solder jet state, the perimeter of the jet shape is smaller than the case where the solder liquid is jet in the abnormal solder jet state. Accordingly, in the case where the perimeter of the jet shape is used as the feature value for determining the abnormality of the jet soldering device 70, the abnormality determination unit 422 performs the following determination. In the case where the perimeter of the jet shape is within the predetermined threshold, the abnormality determination unit 422 determines that the jet soldering device 70 is not abnormal. In the case where the perimeter of the jet shape is greater than the predetermined threshold, the abnormality determination unit 422 determines that the jet soldering device 70 is abnormal.

### (Circularity of Jet Shape)

FIG. 9 illustrates actual values of the circularity of the jet shapes imaged from the top in the cases where the solder liquid is jet by using the jet soldering device 70 in the normal solder jet state and the solder liquid is jet by using the jet soldering device 70 in the abnormal solder jet state (the state in which an one-sided flow occurs). FIG. 9 is a graph in which the horizontal axis is set as time, the vertical axis is set as circularity.

As shown in FIG. 9, in the case where the solder liquid is jet in the normal solder jet state, the circularity of the jet shape is greater than the case where the solder liquid is jet in the abnormal solder jet state. Accordingly, in the case where the circularity of the jet shape is used as the feature value for determining the abnormality of the jet soldering device 70, the abnormality determination unit 422 performs the following determination. In the case where the circularity of the jet shape is equal to or greater than the predetermined threshold, the abnormality determination unit 422 determines that the jet soldering device 70 is not abnormal. In the case where the perimeter of the jet shape is less than the predetermined threshold, the abnormality determination unit 422 determines that the jet soldering device 70 is abnormal.

### (Inscribed Circle Radius of Jet Shape)

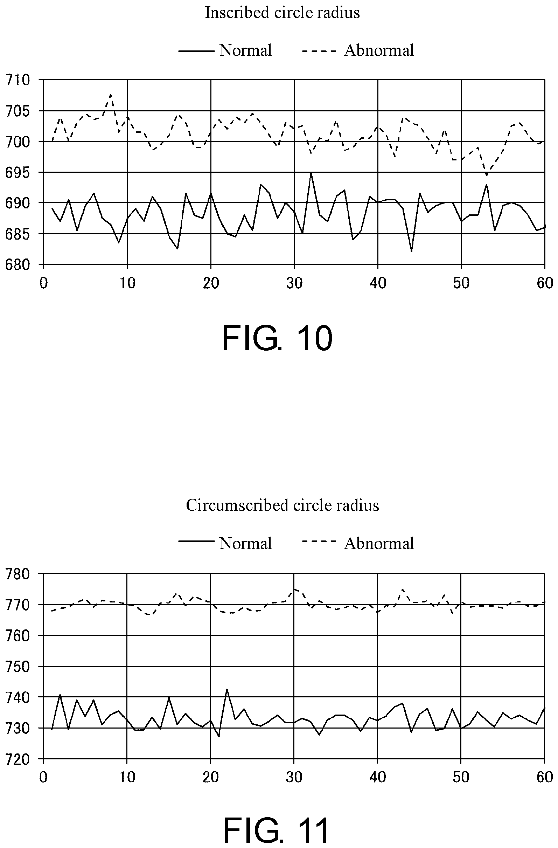

FIG. 10 illustrates actual values of the inscribed circle radius of the jet shapes imaged from the top in the cases where the solder liquid is jet by using the jet soldering device 70 in the normal solder jet state and the solder liquid is jet by using the jet soldering device 70 in the abnormal solder jet state (the state in which an one-sided flow occurs). FIG. 10 is a graph in which the horizontal axis is set as time, the vertical axis is set as the inscribed circle radius of the jet shape.

As shown in FIG. 10, in the case where the solder liquid is jet in the normal solder jet state, the inscribed circle radius of the jet shape is smaller than the case where the solder liquid is jet in the abnormal solder jet state. Accordingly, in the case where the inscribed circle radius of the jet shape is used as the feature value for determining the abnormality of the jet soldering device 70, the abnormality determination unit 422 performs the following determination. In the case where the inscribed circle radius of the jet shape is within the predetermined threshold, the abnormality determination unit 422 determines that the jet soldering device 70 is not abnormal. In the case where the inscribed circle radius is greater than the predetermined threshold, the abnormality determination unit 422 determines that the jet soldering device 70 is abnormal.

### (Circumscribed Circle Radius of Jet Shape)

FIG. 11 illustrates actual values of the circumscribed circle radius of the jet shapes imaged from the top in the cases where the solder liquid is jet by using the jet soldering device 70 in the normal solder jet state and the solder liquid is jet by using the jet soldering device 70 in the abnormal solder jet state (the state in which an one-sided flow occurs). FIG. 11 is a graph in which the horizontal axis is set as time, the vertical axis is set as the circumscribed circle radius of the jet shape.

As shown in FIG. 11, in the case where the solder liquid is jet in the normal solder jet state, the circumscribed circle radius of the jet shape is smaller than the case where the solder liquid is jet in the abnormal solder jet state. Accordingly, in the case where the circumscribed circle radius of the jet shape is used as the feature value for determining the abnormality of the jet soldering device 70, the abnormality determination unit 422 performs the following determination. In the case where the circumscribed circle radius of the jet shape is within the predetermined threshold, the abnormality determination unit 422 determines that the jet soldering device 70 is not abnormal. In the case where the circumscribed circle radius is greater than the predetermined threshold, the abnormality determination unit 422 determines that the jet soldering device 70 is abnormal.

### (Width of Jet Shape)

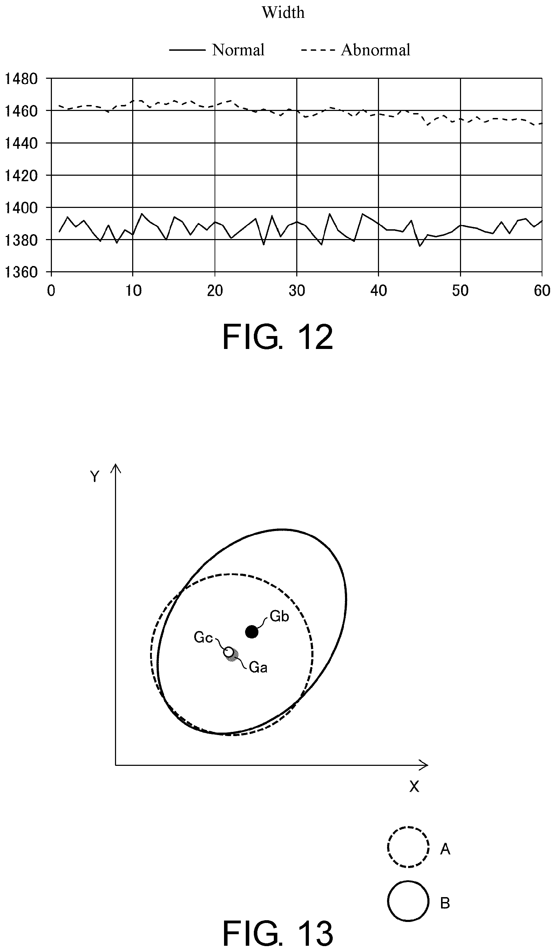

FIG. 12 illustrates actual values of the width of the jet shapes imaged laterally in the cases where the solder liquid is jet by using the jet soldering device 70 in the normal solder jet state and the solder liquid is jet by using the jet soldering device 70 in the abnormal solder jet state (the state in which an one-sided flow occurs). FIG. 12 is a graph in which the horizontal axis is set as time, the vertical axis is set as the width of the jet shape.

As shown in FIG. 12, in the case where the solder liquid is jet in the normal solder jet state, the width of the jet shape is smaller than the case where the solder liquid is jet in the abnormal solder jet state. Accordingly, in the case where the width of the jet shape is used as the feature value for determining the abnormality of the jet soldering device 70, the abnormality determination unit 422 performs the following determination. In the case where the width of the jet shape is within the predetermined threshold, the abnormality determination unit 422 determines that the jet soldering device 70 is not abnormal. In the case where the width of the jet shape is greater than the predetermined threshold, the abnormality determination unit 422 determines that the jet soldering device 70 is abnormal.

Also, while the data is not shown, the actual value of the height of the jet shape imaged laterally is greater in the case where the solder liquid is jet in the normal solder jet state than in the case where the solder liquid is jet in the abnormal solder jet state. That is, in the case where the height of the jet shape is equal to or greater than the predetermined threshold, the abnormality determination unit 422 may determine that the jet soldering device 70 is not abnormal. In the case where the height of the jet shape is less than the predetermined threshold, the abnormality determination unit 422 may determine that the jet soldering device 70 is abnormal.

### (Gravity Center Coordinate)

In the following, the direction in which the solder liquid is jet (upper direction) is set as the Z-axis direction, an arbitrary direction perpendicular to the Z-axis direction is set as the X-axis direction, and an arbitrary direction perpendicular to the Z-axis direction and the X-axis direction is set as the Y-axis direction.

FIG. 13 is a schematic view in which the horizontal axis is set as the X-axis and the vertical axis is set as the Y-axis, and which illustrates the gravity center coordinates of the jet shapes and the jet shapes imaged from the top in the cases where the solder liquid is jet by using the jet soldering device 70 in the normal solder jet state and the solder liquid is jet by using the jet soldering device 70 in the abnormal solder jet state (the state in which an one-sided flow occurs). A of FIG. 13 shows the jet shape in the normal solder jet state, and Ga shows the gravity center coordinate of the jet shape in the normal solder jet state. B of FIG. 13 shows the jet shape in the abnormal solder jet state, and Gb shows the gravity center coordinate of the jet shape in the abnormal solder jet state. In addition, Gc of FIG. 13 shows a reference point.

As shown in FIG. 13, in the case where the solder liquid is jet in the normal solder jet state, the gravity center coordinate of the jet shape is closer to the reference point than the case where the solder liquid is jet in the abnormal solder jet state. Accordingly, in the case where the gravity center coordinate of the jet shape is used as the feature value for determining the abnormality of the jet soldering device 70, the abnormality determination unit 422 performs the following determination. Firstly, the reference point is set in advance in the storage unit 43 as a preferred position for the gravity center coordinate of the jet shape in the normal solder jet state to exist. In the case where the distance from the reference point to the gravity center coordinate of the jet shape is equal to or less than the predetermined threshold, the abnormality determination unit 422 determines that the jet soldering device 70 is not abnormal. Also, in the case where the distance from the reference point to the gravity center coordinate of the jet shape is greater than the predetermined threshold, the abnormality determination unit 422 determines that the jet soldering device 70 is abnormal.

### (Vertex Coordinate)

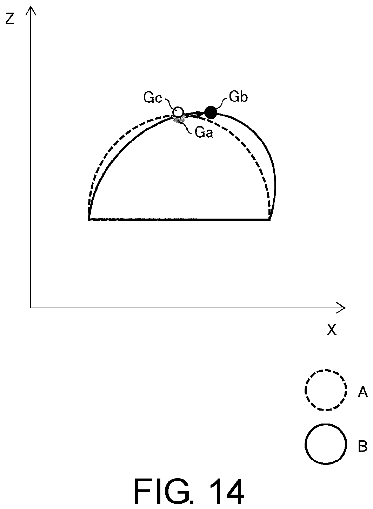

FIG. 14 is a schematic view in which the horizontal axis is set as the X-axis and the vertical axis is set as the Z-axis, and which illustrates the vertex coordinates of the jet shapes and the jet shapes laterally imaged in the cases where the solder liquid is jet by using the jet soldering device 70 in the normal solder jet state and the solder liquid is jet by using the jet soldering device 70 in the abnormal solder jet state (the state in which an one-sided flow occurs). A of FIG. 14 shows the jet shape in the normal solder jet state, and Ga shows the vertex coordinate of the jet shape in the normal solder jet state. B of FIG. 14 shows the jet shape in the case where a nozzle in the abnormal solder jet state is used, and Gb shows the vertex coordinate of the jet shape in the abnormal solder jet state. In addition, Gc of FIG. 14 shows a reference point.

As shown in FIG. 14, in the case where the solder liquid is jet in the normal solder jet state, the vertex position of the jet shape in the horizontal direction is closer to the reference point than the case where the solder liquid is jet in the abnormal solder jet state. Accordingly, in the case where the vertex coordinate (the vertex position in the horizontal direction) of the jet shape is used as the feature value for determining the abnormality of the jet soldering device 70, the abnormality determination unit 422 performs the following determination. Firstly, the reference point is set in advance in the storage unit 43 as a preferred position for the vertex of the jet shape in the horizontal direction under the normal solder jet state to exist. The abnormality determination unit 422 determines the abnormality of the jet soldering device 70 based on the distance from the reference point to the X-axis coordinate of the vertex of the jet shape and the distance from the reference point to the Z-axis coordinate of the vertex of the jet shape. Specifically, in the case where the distance from the reference point to the X-axis coordinate of the vertex of the jet shape is equal to or less than the predetermined threshold (referred to as "first threshold"), and in the case where the distance from the reference point to the Z-axis coordinate of the vertex of the jet shape is equal to or less than the predetermined threshold (referred to as "second threshold"), the abnormality determination unit 422 determines that the jet soldering device 70 is not abnormal. In addition, in the case where one of the distance from the reference point to the X-axis coordinate of the vertex of the jet shape and the distance from the reference point to the Z-axis coordinate of the vertex of the jet shape exceeds the predetermined threshold, the abnormality determination unit 422 determines that the jet soldering device 70 is abnormal.

Besides, the abnormality determination unit 422 may also determine the abnormality of the jet soldering device 70 based on only the X-axis coordinate of the vertex of the jet shape from the reference point. Specifically, in the case where the distance from the reference point to the X-axis coordinate of the vertex of the jet shape is equal to or less than the predetermined threshold, the abnormality determination unit 422 determines that the jet soldering device 70 is not abnormal. In the case where the distance from the reference point to the X-axis coordinate of the vertex of the jet shape exceeds the predetermined threshold, the abnormality determination unit 422 determines that the jet soldering device 70 is abnormal.

In addition, in the case where the distance from the reference point to the vertex of the jet shape in the horizontal direction is equal to or less than the predetermined threshold, the abnormality determination unit 422 determines that the jet soldering device 70 is not abnormal. In the case where the distance from the reference point to the vertex of the jet shape in the horizontal direction is greater than the predetermined threshold, the abnormality determination unit 422 determines that the jet soldering device 70 is abnormal. In the case where there are a plurality of cameras 10b, for the respective jet shapes imaged by the cameras 10b, the abnormality determination unit 42 may obtain the distances from the respective reference points to the respective vertices in the horizontal direction (X-axis direction or Y-axis direction) and make determinations respectively.

The height of the vertex of the jet shape is influenced by the jet velocity of the solder liquid. Meanwhile, the position of the vertex of the jet shape in the horizontal direction is hardly influenced by the jet velocity of the solder liquid. By using the vertex position of the jet shape in the horizontal direction as the feature value, the abnormality determination unit 422 can suitably determine the abnormality of the jet soldering device 70.

### (Notification Instruction Unit 423)

The notification instruction unit 423 receives the signal indicating the abnormality output by the abnormality determination unit 422, and outputs a signal instructing to notify a sign of abnormality to the display input device 50 via the transmission unit 44. Specifically, the notification instruction unit 423 in the embodiment may output a signal instructing to notify a sign of abnormality of the jet state of the solder jet from the nozzle 77.

### (Storage Unit 43)

The storage unit 43 is, for example, an auxiliary storage device such as a flash memory, a solid state drive, etc., and stores the threshold information 431.

### (Transmission Unit 44)

The transmission unit 44 outputs a signal to the external apparatus. In the embodiment, specifically, the transmission unit 44 follows the instruction of the notification instruction unit 423 and output the signal indicating that the jet soldering device 70 is abnormal to the display input device 50.

### (Display Input Device 50)

The display input device 50 is, for example, a touch panel-type display input device. The user of the management system 1 can operate the controller 40 via the display input device 50 and check the operation state of the management system 1 on the display input device 50.

The display input device 50 receives the signal indicating the instruction to notify that the jet soldering device 70 has a sign of abnormality and performs the notification indicating the sign of abnormality. For example, the notification relating to the abnormality may be displayed on a touch panel included in the display input device 50.

### (Support Device)

The support device 60 is a device used by connecting with the management system 1 for various settings in the management system 1, such as the operation settings of the camera 10a, the camera 10b, the image processing device 20, and the jet soldering device 70. The support device 60 can be connected with the management system 1 via the controller 40. An information processing device, such as a personal computer, can be used as the support device 60, or a portable information processing device, such as a notebook computer, can also be used as the support device 60.

### 3. Operation Example

### (Example of Flow of Abnormality Notification Process of Management System 1)

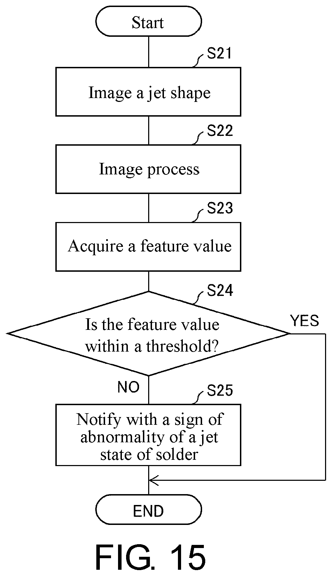

FIG. 15 is a flowchart illustrating an example of a flow of an abnormality notification process of the management system 1. An example of the flow of the abnormality notification process of the management system 1 is described with reference to FIG. 15.

In the example shown in the following, a configuration in which the abnormality determination unit 422 performs abnormality determination by using a feature value whose value is smaller in the case where the solder liquid is jet in the normal solder jet state than the case where the solder liquid is jet in the abnormal solder jet state.

The camera 10a and the camera 10b image the jet shape of the jet solder (S21).

Then, the image processing device 20 performs an image process that calculates the feature value representing the height, the width, the elliptical major axis, the elliptical minor axis, the flatness ratio, the area, the perimeter, the circularity, the inscribed circle radius, the circumscribed circle radius, and the gravity center coordinate, etc., of the jet shape of the solder from the image data output by the camera 10a and the camera 10b (S22).

The processes of S23 to S25 in the following form the abnormality determination process in the controller 40. Then, the acquisition unit 421 acquires the feature value calculated by the image processing device 20. (S23: Acquisition Step) Then, the abnormality determination unit 422 determines whether the feature value for the jet shape is within the predetermined threshold (S24: Abnormality Determination Step).

In the case where the feature value is greater than the predetermined threshold (NO in S24), the display input device 50 notifies with a sign of abnormality regarding the abnormality of the jet state of the solder jet from the nozzle 77 (S25). In addition, in the case where the feature value is within the predetermined threshold (YES in S24), the process is ended.

As an example, a configuration in which the abnormality determination unit 422 performs abnormality determination by using a feature value whose value is greater in the case where the solder liquid is jet in the normal solder jet state than the case where the solder liquid is jet in the abnormal solder jet state is as follows. In the case where the feature value is smaller than the predetermined threshold, the display input device 50 notifies with a sign of abnormality regarding the abnormality of the jet state of the solder jet from the nozzle 77. In addition, in the case where the feature value is equal to or greater than the predetermined threshold (YES in S24), the process is ended.

### (Abnormality Determination Using Multiple Types of Feature Values)

The abnormality determination unit 422 may also perform abnormality determination based on multiple types of feature values. For example, the abnormality determination unit 422 may perform determination based on another feature value in response to a result of performing determination based on a first feature value. The abnormality determination unit 422 may, in response to the result of performing the determination based on the first feature value, make a feature value used as the another feature value different.

For example, in the case where the jet soldering device 70 is temporarily determined as in the normal state based on the first feature value, the abnormality determination unit 422 may further perform abnormality determination based on a second feature value. In the case where the jet soldering device 70 is temporarily determined as in the abnormal state based on the first feature value, the abnormality determination unit 422 may further perform abnormality determination based on a third feature value. The abnormality determination unit 422 may, in response to a result of determination of the second time (the result of the determination according to the second feature value or the third feature value), determine whether jet soldering device 70 is abnormal.

### (Example Realized by Software)

The control program (specifically the acquisition unit 421, the abnormality determination unit 422, and the notification instruction unit 423) of the controller 40 may be realized as a logic circuit (hardware) formed by an integrated circuit (IC chip), etc., and may also be realized by software.

In the latter case, the controller 40 includes a computer that executes the commands of the program which is the software that realizes the respective functions. The computer includes, for example, one or more processors as well as a computer readable recording medium storing the program. Then, in the computer, the processor reads the program from the recording medium and executes the program, thereby achieving the objective of the invention. As the processor, a central processing unit (CPU) can be used. As the recording medium, in addition to a "non-temporary tangible medium" such as a read only memory (ROM), etc., a tape, a disk, a card, a semiconductor memory, a programmable logic circuit, or the like can be used. Further, a random access memory (RAM) for expanding the program may be further provided. Further, the program may be supplied to the computer via an arbitrary transmission medium (communication network, broadcast wave, etc.) capable of transmitting the program. In addition, an aspect of the invention may be realized in the form of data signals embedded in carrier waves, in which the program is embodied through electronic transmission.

The invention is not limited to the above-described embodiments. Various modifications can be made within the scope of the claims, and embodiments obtained by appropriately combining the technical means disclosed in the different embodiments are also included in the technical scope of the invention.

### Embodiment 1

### (Example of Abnormality Determination Using Multiple Types of Feature Values)

An embodiment of the invention is described in the following. The abnormality determination of the jet soldering device 70 is performed based on multiple types of feature values by using the management system 1. First, data of 100 cases of jet shapes are acquired and the determination on flatness ratio is performed by using the management system 1 (Determination 1). Specifically, the abnormality determination unit 422 determines that the state is a normal state in the case where the flatness ratio exceeds 0.9, and determines that the state is an abnormal state in the case where the flatness ratio is equal to or less than 0.9. Among the determination results, the jet soldering device 70 is determined as in the normal state in 70 cases, and the jet soldering device 70 is determined as in the abnormal state in 30 cases.

Then, by using the management system 1, the determination is performed on the X-axis coordinates of the gravity center coordinates of the jet shapes of the jet soldering device 70 in the 70 cases determined as in the normal state based on the flatness ratio (Determination 2). Specifically, the abnormality determination unit 422 determines that the state is a normal state in the case where the X-axis coordinate of the gravity center coordinate is less than 2, and determines that the state is an abnormal state in the case where the X-axis coordinate of the gravity center coordinate exceeds 2. Among the determination results, the jet soldering device 60 is determined as in the normal state in 70 cases, and the jet soldering device 70 is determined as in the abnormal state in 10 cases.

Then, by using the management system 1, the determination is performed on the X-axis coordinates of the vertex coordinates of the jet shapes of the jet soldering device 70 in the 30 cases determined as in the abnormal state based on the flatness ratio (Determination 3). Specifically, the abnormality determination unit 422 determines that the state is a normal state in the case where the X-axis coordinate of the vertex coordinate is less than 3, and determines that the state is an abnormal state in the case where the X-axis coordinate of the vertex coordinate exceeds 3. Among the determination results, the jet soldering device 10 is determined as in the normal state in 70 cases, and the jet soldering device 70 is determined as in the abnormal state in 20 cases.

Here, regarding the 100 cases of the jet soldering device 70, there are 70 cases that are actually in the normal state and 30 cases that are actually in the abnormal state. In addition, among the 70 cases determined as in the normal state in Determination 1, there are 60 cases that are actually in the normal state and 10 cases that are actually in the abnormal state. In other words, in Determination 1, the data of 10 cases that are actually in the abnormal state are overlooked. In addition, among the 70 cases determined as in the abnormal state in Determination 1, there are 20 cases that are actually in the abnormal state and 10 cases that are actually in the normal state. In other words, in Determination 1, the data of 10 cases that are actually in the normal state are determined as in the abnormal state. From the above, in the case where the determination on 100 cases is performed based on only one type of feature values (flatness ratio), there are 20 cases that are determined erroneously, and the identification success rate is 80%.

Meanwhile, among the 60 cases determined as in the normal state in Determination 2, there are 60 cases that are actually in the normal state and 0 cases that are actually in the abnormal state. In addition, among the 10 cases determined as in the abnormal state in Determination 1, there are 10 cases that are actually in the abnormal state and 0 cases that are actually in the normal state. That is, in the case where the determination is performed based on two types of feature values, there are 0 cases that are determined erroneously, and the identification success rate is 100%.

In addition, among the 10 cases determined as in the normal state in Determination 3, there are 10 cases that are actually in the normal state and 0 cases that are actually in the abnormal state. In addition, among the 20 cases determined as in the abnormal state in Determination 1, there are 20 cases that are actually in the abnormal state and 0 cases that are actually in the normal state. That is, in the case where the determination is performed based on two types of feature values, there are 0 cases that are determined erroneously, and the identification success rate is 100%.

According to the above, by performing determination based on the X-axis coordinate of the gravity center coordinate and the X-axis coordinate of the vertex coordinate after performing determination based on flatness ratio, the identification success rate is increased. That is, by performing abnormality determination based on multiple types of feature values, the determination accuracy can be even higher than the abnormality determination based on one type of feature values.

### Description of Symbols

1: Management system
10a, 10b: Camera
20: Image processing device
40: Controller (information processing device)
421: Acquisition unit
422: Abnormality determination unit
70: Jet soldering device
S23: Acquisition Step
S24: Abnormality Determination Step

## Claims

1. An information processing device, comprising:
an acquisition unit, acquiring a feature value for an imaged jet shape of solder jet in a jet soldering device; and
an abnormality determination unit, determining an abnormality of the jet soldering device by using the feature value.

2. The information processing device as claimed in claim 1, wherein the abnormality determination unit determines the abnormality of the jet soldering device by using the feature value of the jet shape that is imaged from top.

3. The information processing device as claimed in claim 2, wherein the abnormality determination unit determines the abnormality of the jet soldering device by using, as the feature value, at least one of an elliptical major axis, an elliptical minor axis, a flatness ratio, an area, a perimeter, circularity, an inscribed circle radius, a circumscribed circle radius, and a gravity center coordinate of the jet shape imaged from the top.

4. The information processing device as claimed in claim 1, wherein the abnormality determination unit determines the abnormality of the jet soldering device by using the feature value of the jet shape that is imaged laterally.

5. The information processing device as claimed in claim 4, wherein the abnormality determination unit determines the abnormality of the jet soldering device by using, as the feature value, a width of the jet shape imaged laterally or a position of a vertex of the jet shape in a horizontal direction.

6. A management system, comprising:
a camera, imaging a jet shape of a solder liquid jet in a jet soldering device;
an image processing device, calculating a feature value for the jet shape from an image imaged by the camera; and
the information processing device as claimed in any one of claims 1 to 5.

7. A control program, which is a control program for a computer to function as the information processing device as claimed in claim 1, wherein the computer functions as the acquisition unit and the abnormality determination unit.

8. A control method of an information processing device, the control method comprising:
an acquisition step for acquiring a feature value for an imaged jet shape of solder jet in a jet soldering device; and
an abnormality determination step for determining an abnormality of the jet soldering device by using the feature value.
